# EUROPÄISCHE PATENTSCHRIFT

(11) **EP 3 251 213 B1**
(45) Veröffentlichungstag und Bekanntmachung des Hinweises auf die Patenterteilung: **20.02.2019**
(21) Anmeldenummer: 15820546.8
(22) Anmeldetag: 30.12.2015
(51) Int. Cl.: H03K 17/96, G06F 3/044, D06F 39/00

(54) **BERÜHRUNGSEMPFINDLICHES, BELEUCHTBARES BEDIENPANEL, VERFAHREN ZU SEINEM BETRIEB SOWIE DIESES BEDIENPANEL ENTHALTENDES HAUSGERÄT**
TOUCH-SENSITIVE ILLUMINABLE OPERATING PANEL, METHOD FOR OPERATING SAME, AND DOMESTIC APPLIANCE CONTAINING SAID OPERATING PANEL
PANNEAU DE COMMANDE TACTILE ÉCLAIRÉ, PROCÉDÉ PERMETTANT DE FAIRE FONCTIONNER LEDIT PANNEAU DE COMMANDE, AINSI QU'APPAREIL MÉNAGER MUNI DUDIT PANNEAU DE COMMANDE

(30) Priorität: 28.01.2015 DE 102015201427
(43) Veröffentlichungstag der Anmeldung: 06.12.2017
(73) Patentinhaber: BSH Hausgeräte GmbH, 81739 München (DE)
(72) Erfinder: METZ, Florian, 85774 Unterföhring (DE); WEBER, Carsten, 73431 Aalen (DE); KRUG, Raphael, 80636 München (DE)
(86) Internationale Anmeldenummer: PCT/EP2015/081442
(87) Internationale Veröffentlichungsnummer: WO 2016/119991

(56) Entgegenhaltungen:
- EP-A2- 1 970 479
- DE-A1- 10 326 948
- DE-A1-102011 077 896
- US-A1- 2009 046 065
- US-A1- 2010 187 023

## Beschreibung

Die Erfindung betrifft ein berührungsempfindliches, beleuchtbares Bedienpanel, ein Verfahren zu seinem Betrieb sowie ein dieses Bedienpanel enthaltendes Hausgerät. Die Erfindung betrifft insbesondere ein berührungsempfindliches, beleuchtbares Bedienpanel, umfassend ein Substrat, eine Vielzahl von Berührelementen auf einer Oberfläche des Bedienpanels, eine Sensorschicht mit einer Vielzahl von Sensorelementen, wobei jedes Sensorelement einem Berührelement auf einer Oberfläche des Bedienpanels zugeordnet ist, eine Beleuchtungsvorrichtung, welche eingerichtet ist, um mindestens einen Teil der Berührelemente zu beleuchten, sowie eine Steuereinheit.

Hausgeräte weisen im Allgemeinen ein Bedienpanel auf, das die Möglichkeit der Einstellung von im Hausgerät durchzuführenden Programmen bietet, sowie eine Darstellung von Informationen über die Durchführung eines ausgewählten Programms. Hausgeräte sind hierbei beispielsweise Wäschebehandlungsgeräte wie Waschmaschinen, Trockner und Waschtrockner, Geschirrspülmaschinen, Mikrowellengeräte, Backöfen und -herde, Mixgeräte, Kaffeemaschinen usw. Die Darstellung von Informationen und ausgewählten Programmen erfolgt hierbei im Allgemeinen über ein optisches Display, bei dem oft einzelnen Displaybereichen zugeordnete Programme durch Beleuchtung der Displaybereiche hervorgehoben und damit insbesondere deren Durchführung angezeigt werden kann.

So beschreibt die DE 10 2007 048 222 A1 einen berührungsempfindlichen Bildschirm, bei dem mindestens eine kapazitive Sensortaste als Flächenelektrode auf einer transparenten Trägerplatte in Drucktechnik hergestellt ist, wobei die transparente Trägerplatte insbesondere aus Glas oder Kunststoff ist und die Flächenelektroden mit transparentem Leitlack auf der der Bedienungsseite gegenüberliegenden Rückseite der transparenten Trägerplatte gedruckt werden.

Die DE 10 2011 077896 A1 beschreibt eine Bedien-und Anzeigeeinrichtung für ein Haushaltsgerät, mit Bedienmitteln zum Einstellen zumindest eines Parameters eines Betriebsprozesses des Haushaltsgeräts,mit einem Lichtleiterteil und mit einer Leuchteinrichtung.

Die DE 10 2009 045 665 A1 beschreibt eine Bedieneinrichtung für ein Hausgerät mit einer berührsensitiven Bedienfläche, einer Anzeigeeinheit und einem Distanzrahmen, durch welche die Bedienfläche und die Anzeigeeinheit beabstandet voneinander angeordnet sind, wobei der Distanzrahmen einstückig mit einem Gehäuseteil eines Gehäuses der Bedieneinrichtung ausgebildet ist.

Das chinesische Gebrauchsmuster CN00020117490Y beschreibt eine Bedieneinrichtung für ein Hausgerät, das mit einem berührungsempfindlichen Schalter ausgestattet ist, das ein semitransparentes Panel sowie einen leitfähigen Film, der Berührungen in elektrische Signale umwandelt, innerhalb des semitransparenten Panels umfasst.

Die WO 2007/062935 A1 beschreibt ein Anzeigeelement mit einer Leuchtdiode und einem von der Leuchtdiode hinterleuchteten Anzeigefeld, wobei der Strahlengang des Lichts in dem Anzeigeelement wenigstens zwei Licht streuende Elemente passiert. Das Licht streuende Element kann beispielsweise eine Linse, insbesondere eine Zylinderlinse, eine Mattscheibe oder eine auf dem Anzeigefeld aufgetragene Lackschicht sein.

Die DE 10 2011 006 402 A1 beschreibt eine Bedienblende eines Hausgerätes, die aus einem Kunststoffmaterial besteht, welches in plastifiziertem Zustand in eine Spritzgießform einspritzbar ist und somit einen Blendenkunststoff bildet, und mindestens einen Teilabschnitt zur Aufnahme von Berührelementen aufweist, welche von einem Berührelemente-Folienstreifen, der mittels eines Spritzgießvorgangs zur Herstellung der Bedienblende, insbesondere an einer Oberfläche der Bedienblende, lagegerecht und dauerhaft mit dem Blendenkunststoff verbunden ist, aufgenommen werden.

Die DE 10 2012 217 889 A1 beschreibt ein Verfahren zum Anzeigen und Einstellen von Parametern und zugeordneten Wertangaben für eine Bedien- und Anzeigeeinrichtung in einer programmgesteuerten Haushaltmaschine mit einem elektronischen Display, auf dem mehrere Anzeigefelder für jeweils unterschiedliche alphanumerische Wertangaben von in unterschiedlichen Programmgruppen wiederkehrenden Parametern angeordnet sind, die durch eine Eingabeeinrichtung für die Auswahl zu einem Bearbeitungsprozess in der Maschine wirksam geschaltet werden können, wobei die Breite der Anzeigefelder automatisch an die Länge der Wertangaben angepasst wird.

Die DE 10 2010 028 164 A1 beschreibt eine Bedieneinrichtung für ein Haushaltsgerät, mit einer berührsensitiven Bedienfläche und einer Anzeigeeinheit mit einem Gehäuse und einem Schaltungsträger, wobei das Gehäuse lösbar mit dem Schaltungsträger verbunden ist.

Die EP 1 970 479 A2 beschreibt ein Bedienpanel zur Kontrolle des Betriebs eines Apparates, wobei das Bedienpanel umfasst: einen semitransparenten Deckel; einen hinter dem Deckel angeordneten Film, der mit einer Vielzahl von Charakteren oder Symbolen bedruckt ist; ein detektierendes Panel hinter dem Film, das eine Vielzahl von detektierenden Mitgliedern hat, um eine Kapazität eines menschlichen Körpers nachzuweisen; eine Schalttafel mit einer Licht emittierenden Einheit, welche Licht auf den Film leitet, um die Charaktere oder Symbole des Films auf einer hinteren Oberfläche des semitransparenten Deckels anzuzeigen; und ein Führungsmitglied mit einer Vielzahl von optischen Pfaden, welche das von der Licht emittierenden Einheit abgestrahlte Licht in jeden der Charaktere oder Symbole des Films leitet.

Hausgeräte gestatten es zunehmend einem Benutzer, unter einer Vielzahl von Bedienungsprogrammen und Optionen auszuwählen. Sofern das Hausgerät zur Behandlung von darin platzierten Gegenständen dient (z.B. von Wäschestücken, Geschirr), können zudem Eigenschaften der zu behandelnden Gegenstände eingegeben werden (z.B. Verschmutzungsgrad, Art, Zusammensetzung). Dadurch ermöglichen es viele Hausgeräte, auf die speziellen Bedürfnisse eines Benutzers des Hausgerätes präzise eingehen zu können. Allerdings nimmt dadurch auch die Anzahl der Eingabemöglichkeiten zu. Darunter leidet einerseits die Übersichtlichkeit bei der Darstellung von durchführbaren Programmen, Optionen und sonstigen Eingaben. Andererseits führt eine Erhöhung der Anzahl der Eingabemöglichkeiten im Allgemeinen auch zu einer Erhöhung der Zahl der Bedientasten. Aufgrund des begrenzten Raumes für Eingaben kann dies zu Fehleingaben führen, wenn beispielsweise die Bedientasten auf einem druckempfindlichen Bedienpanel zu eng beieinanderliegen.

Vor diesem Hintergrund war es Aufgabe der vorliegenden Erfindung, ein berührungsempfindliches, beleuchtbares Bedienpanel bereitzustellen, das bei einer vereinfachten, übersichtlicheren Bedienbarkeit dennoch zahlreiche Einstellmöglichkeiten für Bedienprogramme, Optionen und sonstige Eingaben ermöglicht. Aufgabe der Erfindung war außerdem die Bereitstellung eines Verfahrens für den Betrieb dieses Bedienpanels sowie eines Hausgerätes, welches dieses Bedienpanel enthält.

Die Lösung dieser Aufgabe wird nach dieser Erfindung erreicht durch ein berührungsempfindliches, beleuchtbares Bedienpanel, ein Verfahren zu seinem Betrieb sowie ein dieses Bedienpanel enthaltendes Hausgerät mit den Merkmalen der jeweiligen unabhängigen Patentansprüche. Bevorzugte Ausführungsformen des erfindungsgemäßen Bedienpanels, des Verfahrens zu seinem Betrieb sowie des dieses Bedienpanel enthaltenden Hausgeräts sind in entsprechenden abhängigen Patentansprüchen aufgeführt.

Gegenstand der Erfindung ist somit ein berührungsempfindliches, beleuchtbares Bedienpanel, umfassend ein Substrat, eine Vielzahl von Berührelementen auf einer Oberfläche des Bedienpanels, eine Sensorschicht mit einer Vielzahl von Sensorelementen, wobei jedes Sensorelement einem Berührelement zugeordnet ist, eine Beleuchtungsvorrichtung, welche eingerichtet ist, um mindestens einen Teil der Berührelemente zu beleuchten, sowie eine Steuereinheit, wobei die Berührelemente mindestens zwei Obertasten Oₘ und mindestens zwei Gruppen Gₙ von Untertasten Bₓⁿ mit m, n, x jeweils ≥ 1 aufweisen, wobei schalttechnisch jeder Obertaste Oₘ mindestens eine Gruppe Gₙ von Untertasten Bₓⁿ derart zugeordnet ist, so dass bei Berührung einer Obertaste Oₘ die Untertasten Bₓⁿ aktiviert werden, welche zur zugeordneten Gruppe Gₙ gehören.

Der hierin verwendete Begriff "Berührelemente" ist breit zu interpretieren. Hierzu gehören neben berührungsempfindlichen Tasten auch berührungsempfindliche Berührelemente mit analoger Eingabe, die im Allgemeinen als "Slider" oder "Wheel" bezeichnet werden. "Obertasten" und "Untertasten" sind im Allgemeinen berührungsempfindliche Tasten.

In einer bevorzugten Ausführungsform des Bedienpanels ist auf dem Substrat eine mindestens teilweise lichtdurchlässige Folie mit Sensorelementen und einer elektrischen Leitstruktur angeordnet (hierin auch als "Sensorfolie" bezeichnet). Zu einer elektrischen Leitstruktur gehören dabei insbesondere auch elektrische Schaltkreise. Überdies können an der Sensorfolie auch elektrische Anschlüsse angeordnet sein.

Das Material der Sensorfolie ist nicht eingeschränkt, solange eine ausreichende Lichtdurchlässigkeit bereitgestellt werden kann. Verwendet werden insbesondere PET (Polyethylenterephthalat), Polyethylen, Polypropylen, Polyetheretherketon, Polycarbonat, Polyoxymethylen oder ABS. Vorzugsweise besteht die berührungsempfindliche Folie aus Polyethylenterephthalat.

Die Sensorelemente sind im Allgemeinen als Sensorflächen oder Sensorelektroden aus einem geeigneten Material gestaltet. Das in der Sensorschicht verwendete Sensorelement kann auf verschiedenen Messprinzipien beruhen, wie beispielsweise einer Messung des elektrischen Widerstands oder der elektrischen Kapazität. Vorzugsweise wird eine elektrische Kapazität gemessen, so dass die Sensorelemente bevorzugt kapazitive Sensoren (Sensorelektroden) sind. Dabei bestehen die Sensorelektroden aus einem geeigneten elektrisch leitfähigen Material, dessen Kapazitätsänderung bei Berührung ermittelt und ausgewertet werden kann. Geeignete elektrisch leitfähige Materialien sind beispielsweise transparente Halbleiteroxide oder aber elektrisch leitfähige organische Materialien wie elektrisch leitfähige organische Polymere.

Wird eine Sensorfolie verwendet, so können die Sensorelemente sowie elektrische Leiterbahnen auf unterschiedlichste Weise auf die Sensorfolie aufgebracht werden. In einer bevorzugten Ausführungsform der Erfindung sind mindestens eine kapazitive Sensorelektrode sowie die elektrischen Leiterbahnen auf die Sensorfolie gedruckt.

Neben metallischen leitenden Strukturen können auf den in bevorzugten Ausführungsformen eingesetzten Sensorfolien auch organische leitende Strukturen eingesetzt werden. Im Allgemeinen umfassen daher in Ausführungsformen, bei denen das Sensorelement ein kapazitiver Sensor ist, der mindestens eine kapazitive Sensor und/oder die elektrischen Leiterbahnen ein intrinsisch leitfähiges organisches Polymer oder ein metallisches Leitmaterial oder bestehen aus diesem.

Sofern ein metallisches Leitmaterial erzeugt werden soll, werden vorzugsweise metallhaltige Leitpasten eingesetzt und aufgedruckt. Im Allgemeinen werden diese anschließend gehärtet oder eingebrannt.

Intrinsisch leitfähige organische Polymere sind Polymere, die über ein konjugiertes Elektronensystem verfügen und insbesondere im oxidierten Zustand eine deutlich höhere elektrische Leitfähigkeit zeigen als im neutralen Zustand. Beispiele hierfür sind Polythiophen, Polypyrrol, Polyparaphenylen und Polyvinylenphenylen sowie deren substituierte Abkömmlinge. Bei Verwendung dieser Materialien können beispielsweise polymere organische Elektronikbauteile wie Dioden, Transistoren, Kondensatoren oder Sensoren hergestellt werden, und auch integrierte Schaltkreise. Dabei haben diese Materialien den Vorteil, dass sie durch Drucken auf Kunststofffolien aufgebracht werden können.

Überdies ist im Bedienpanel vorzugsweise auch eine Displayfolie vorhanden, auf welcher verschiedene Symbole und Schriftzeichen angeordnet sind, deren Inhalte auf das Einsatzgebiet des Bedienpanels bzw. des mittels des Bedienpanels gesteuerten Geräts, insbesondere Hausgerätes, abgestimmt sind. Alternativ können die Symbole und Schriftzeichen auch auf der Sensorfolie angeordnet sein, insbesondere aufgeklebt oder aufgedruckt sein.

Das Material der Displayfolie ist nicht besonders eingeschränkt, solange auf dieser Symbole zur Kennzeichnung von Abläufen oder Zuständen im Haushaltsgerät aufgebracht werden können. Im Allgemeinen wird durch eine geeignete Beschichtung auch sichergestellt, dass nur der für eine Anzeige von Informationen vorgesehene Bereich von einem Leuchtmittel beleuchtet werden kann.

Vorzugsweise ist die Displayfolie eine Streufolie, welche Ausnehmungen für anzuzeigende Symbole aufweist. Da beispielsweise LEDs weitestgehend nur punktuelles Licht liefern, sorgt die Folie dafür, dass dieses Licht gestreut wird und somit die Beleuchtung gleichmäßig und gut ablesbar wird. Ganz besonders bevorzugt besteht die Displayfolie aus Polycarbonat, auf dem noch geeignete Lackschichten oder mittels Lacken darstellbare Symbole aufgedruckt sein können. Die Beschichtung kann in Form von Linien, Mustern, Bahnen, Symbolen, Zeichen und dergleichen aufgebracht werden, z.B. als Siebdrucklack, der anschließend getrocknet wird.

Bei Verwendung einer Displayfolie und/oder einer Sensorfolie haben diese jeweils vorzugsweise eine Dicke von 5 bis 500 µm, insbesondere von 25 bis 200 µm.

Die Beschichtungstechniken für die Sensorfolie wie auch die Displayfolie sind nicht besonders eingeschränkt, solange eine ausreichende Haftung auf der Sensorfolie wie auch auf der Displayfolie gewährleistet ist. Die Drucktechniken sind nicht besonders eingeschränkt. Vorzugsweise erfolgt das Drucken durch Siebdruck.

In einer bevorzugten Ausführungsform des Bedienpanels sind die mindestens zwei Gruppen von Untertasten Bₓⁿ derart angeordnet, dass jeder Untertaste Bₓ¹ einer Gruppe G₁ mindestens zwei Untertasten Bₓ² einer davon unterschiedlichen Gruppe G₂ unmittelbar benachbart sind.

In einer weiteren bevorzugten Ausführungsform sind die Untertasten Bₓⁿ in einer rechteckigen Matrix angeordnet, so dass jeder Untertaste Bₓⁿ mindestens zwei seitlich benachbarte und mindesten eine diagonal benachbarte Untertaste Bₓⁿ zugeordnet sind.

Die Gruppen Gₙ können eine gleiche oder unterschiedliche Anzahl von Untertasten Bₓⁿ aufweisen. Für verschiedene n kann also x unterschiedlich sein. Je nach Anzahl der Untertasten Bₓⁿ sowie dem Verhältnis zwischen der Zahl der Untertasten in den Gruppen Gₙ können für die Anordnung der Untertasten verschiedene Möglichkeiten gewählt werden. Sind beispielsweise in einer Gruppe G₁ mehr Untertasten vorhanden als in einer Gruppe G₂, so kann eine Anordnung der Untertasten in einer rechteckigen Matrix vorteilhaft sein, bei welcher jeder Untertaste Bₓ² der Gruppe G₂ zwei seitlich benachbarte und mindestens eine diagonal benachbarte Untertaste Bₓ¹ der Gruppe G₁ zugeordnet sind.

Im erfindungsgemäßen Bedienpanel werden die Untertasten Bₓⁿ im Allgemeinen dadurch aktiviert, dass durch die Steuereinheit jeder Untertaste Bₓⁿ ein bei Berührung der Untertaste Bₓⁿ auszuführender Schritt zugeordnet ist.

Es ist erfindungsgemäß bevorzugt, dass die Steuereinrichtung und die Beleuchtungsvorrichtung im Bedienpanel ausgestaltet sind, um bei Berührung einer Obertaste O₁ die Untertasten Bₓ¹ mindestens einer zugeordneten Gruppe G₁ zu beleuchten.

Überdies ist es erfindungsgemäß bevorzugt, dass Steuereinrichtung und Beleuchtungsvorrichtung im erfindungsgemäßen Bedienpanel derart ausgestaltet sind, dass bei einer Beleuchtung der Untertasten Bₓ¹ einer Gruppe G₁ die unmittelbar benachbarten Untertasten Bₓ² einer Gruppe G₂ nicht beleuchtet werden. Dies führt dazu, dass die Benutzerfreundlichkeit des Bedienpanels deutlich besser ist, da für den Benutzer die aktiven Bedientasten durch Beleuchtung hervorgehoben sind.

Das Substrat ist erfindungsgemäß nicht beschränkt, solange eine ausreichende Transparenz und sonstige auf den jeweiligen Verwendungszweck angepasste Eigenschaften realisiert werden können. So kann das Substrat Glas, Glaskeramik oder einen Kunststoff enthalten oder aus diesen bestehen. Vorzugsweise beinhaltet das Substrat eine Glasplatte.

Die Sensorelemente können direkt oder in einer Sensorfolie ausgebildet auf dem Substrat angeordnet sein. Bevorzugt sind auf einer Glasplatte als Substrat Sensorelemente direkt oder in einer Sensorfolie ausgebildet angeordnet.

Die Beleuchtungsvorrichtung weist mindestens ein Leuchtmittel auf. Vorzugsweise ist das Leuchtmittel eine anorganische oder organische Leuchtdiode.

Hierbei können neben den bekannten anorganischen Leuchtdiodenmaterialien organische Leuchtdioden eingesetzt werden. Organische Leuchtdioden benutzen im Allgemeinen kleine organische Moleküle (SM-OLEDs) oder organische Polymere (PLEDs). SM-OLEDs umfassen beispielsweise organometallische Chelate und konjugierte Dendrimere. PLEDs umfassen elektrisch leitfähige Polymere wie z.B. Polythiophene, Polypyrrole, Polyfluorene und Poly-(p-phenylenvinylene), die ggf. geeignet substituiert sein können. Bevorzugte Substituenten sind Alkyl- und Alkoxygruppen.

Der Vorteil von PLEDs ist die Möglichkeit, diese als flexible Filme, erhalten beispielsweise durch Elektropolymerisation der entsprechenden Monomere, Spincoaten oder Drucken (Siebdruck) der Polymere einzusetzen, wobei außerdem der Strombedarf für die PLEDs relativ gering ist.

Die Anzahl der eingesetzten Leuchtmittel, z.B. Leuchtdioden, kann erfindungsgemäß sehr variieren, wobei auch mit unterschiedlichen Farben leuchtende Leuchtdioden eingesetzt werden können, um beispielsweise mehrere Informationen anzuzeigen.

In einer bevorzugten Ausführungsform des Bedienpanels ist den Untertasten Bₓⁿ und den Obertasten Oₘ jeweils ein Lichtschacht zugeordnet, so dass Licht aus mindestens einem Leuchtmittel der Beleuchtungsvorrichtung durch den Lichtschacht in Richtung der jeweiligen Untertaste Bₓⁿ oder Obertaste Oₘ geleitet werden kann. Der Lichtschacht ist nicht besonders eingeschränkt, solange er seine Aufgabe, das Licht vom Leuchtmittel zur jeweiligen Untertaste oder Obertaste zu leiten, erfüllt. Der Lichtschacht kann einen über seine Länge einheitlichen inneren Querschnitt haben oder sich in Richtung vom Leuchtmittel zum Berührelement verbreitern oder verjüngen. Außerdem kann der Lichtschacht mit einer Reflektionsschicht versehen sein. Die Ausgestaltung des Lichtschachtes hängt im Allgemeinen von der Art und der Anzahl, insbesondere der Art, des Leuchtmittels ab.

So emittieren Leuchtdioden, vor allem weiße und blaue Leuchtdioden, häufig einen stark gebündelten Strahl, der, wenn er direkt aufs Auge trifft, als blendend empfunden wird. Wenn solche Leuchtdioden im erfindungsgemäßen Bedienpanel eingesetzt werden, wird vorzugsweise darauf geachtet, dass ein direkter Blick auf die Leuchtdiode nicht möglich ist. Aufgrund der starken Bündelung kann eine solche Leuchtdiode außerdem nur eine kleine Fläche auf der Oberfläche des Bedienpanels ausleuchten, diese aber sehr grell. Es ist daher erfindungsgemäß vorteilhaft, zwischen Leuchtmittel und der Oberfläche des Bedienpanels mindestens ein Licht streuendes Element anzuordnen, beispielsweise eine Linse oder eine Streufolie. Eine Linse könnte beispielsweise in oder am Ende des Lichtschachtes angeordnet sein.

Es ist erfindungsgemäß bevorzugt, dass jedem Lichtschacht eine anorganische oder organische Leuchtdiode zugeordnet ist.

Im Lichtschacht kann sich Luft oder ein Lichtleiter, z.B. aus Polycarbonat, befinden.

In einer Ausführungsform weist das Bedienpanel ein aus mehreren Schichten bestehendes Kunststoffbauteil auf, umfassend
(a) eine Displayfolie;
(b) eine Sensorfolie, welche mindestens einen kapazitiven sowie elektrische Leiterbahnen aufweist; und
(c) eine strukturierte Lichtleiterschicht;
wobei das Kunststoffbauteil erhältlich ist durch Durchführen der Schritte
(i) Verbinden einer selbstklebenden Displayfolie mit der Sensorfolie; und
(ii) ein anschließendes Hinterspritzen der Sensorfolie mit einem lichtleitenden Kunststoff, um eine strukturierte Lichtleiterschicht zu erhalten.

Vorzugsweise besteht die dabei verwendete Lichtleiterschicht aus Polycarbonat oder umfasst Polycarbonat.

Die Displayfolie sowie die Sensorfolie bestehen bei dieser Ausführungsform neben den zur Beschichtung verwendeten Materialien jeweils aus einer Kunststofffolie. Diese Folien sind im Allgemeinen flexible Kunststofffolien aus PET (Polyethylenterephathalat), Polyethylen, Polypropylen, Polyetheretherketon, Polycarbonat, Polyoxymethylen oder ABS.

Vorzugsweise wird ein im Schritt (i) erhaltenes Laminat aus der Displayfolie und der Sensorfolie in ein Formwerkzeug einer Spritzgussmaschine eingeführt und anschließend das Hinterspritzen mit einer viskosen Masse des lichtleitenden Kunststoffes durchgeführt.

Zuvor wird die Displayfolie im Allgemeinen durch geeignete Beschichtung mit lichtundurchlässigen Substanzen, z.B. Lacken, so ausgestaltet, dass sie die für ihren Gebrauch erforderlichen Symbole sowie lichtdurchlässigen Bereiche aufweist.

Außerdem wird im Allgemeinen die Sensorfolie, die aus einem Kunststoff besteht, geeignet mit einem der oben erwähnten leitfähigen Materialien strukturiert.

Dies kann beispielsweise nach dem in der WO 2007/090586 A beschriebenen Verfahren geschehen. Daneben können strukturierte Schichten auch dadurch hergestellt werden, dass ein zunächst vollständig beschichtetes Substrat entsprechend einem zu erzielenden metallischen leitfähigen Muster mit einem geeigneten Ätzmedium behandelt wird. Ggf. kann eine vollflächig aufgebrachte Schicht auch durch Laserablation strukturiert werden.

Die Signale der Sensorelemente, in bevorzugten Ausführungsformen der kapazitiven Sensoren, müssen ausgewertet werden, damit über diese eine Steuerung des Bedienpanels und damit beispielsweise eines Hausgerätes stattfinden kann. Hierzu sind die Sensorelemente im Allgemeinen mit einer entsprechenden Auswerteelektronik verbunden. Diese befindet sich im Allgemeinen auf einer dem Bedienpanel benachbarten Leiterplatte.

In einer bevorzugten Ausführungsform der Erfindung wird eine Sensorfolie über ein flaches Anschlussteil (auch als "Tail" bezeichnet), das Leiterbahnen und/oder Verbindungspads (connector pads) aufweist, mit einer Leiterplatte verbunden. Auf der Leiterplatte sind vorzugsweise Stecker, Leuchtdioden und/oder die Auswerteelektronik für Berührungen der Sensorfolie angeordnet.

Gegenstand der Erfindung ist außerdem ein Verfahren zum Betrieb eines berührungsempfindlichen, beleuchtbaren Bedienpanels, umfassend ein Substrat, eine Vielzahl von Berührelementen auf einer Oberfläche des Bedienpanels, eine Sensorschicht mit einer Vielzahl von Sensorelementen, wobei jedem Sensorelement ein Berührelement zugeordnet ist, eine Beleuchtungsvorrichtung, welche eingerichtet ist, um mindestens einen Teil der Berührelemente zu beleuchten, sowie eine Steuereinheit, wobei die Berührelemente mindestens zwei Obertasten Oₘ und mindestens zwei Gruppen Gₙ von Untertasten Bₓⁿ mit m, n, x jeweils ≥ 1 aufweisen, wobei schalttechnisch jeder Obertaste Oₘ mindestens eine Gruppe Gₙ von Untertasten Bₓⁿ derart zugeordnet ist, so dass bei Berührung einer Obertaste Oₘ die Untertasten Bₓⁿ aktiviert werden, welche zur zugeordneten Gruppe Gₙ gehören, und wobei das Verfahren beinhaltet, dass zur Auswahl einer Gruppe von Funktionen, die vom Bedienpanel zu steuern sind, eine dieser Gruppe von Funktionen zugeordnete Obertaste O₁ berührt wird und nach der Berührung der Obertaste O₁ die Steuereinheit eine elektrische Anbindung der Untertasten Bₓⁿ so steuert, dass nur die Untertasten Bₓ¹, welche zur zugeordneten Gruppe G₁ gehören, bei Berührung die Durchführung eines Schrittes veranlassen können.

Vorteilhaft wird dabei die Beleuchtungsvorrichtung so gesteuert, dass nur die Untertasten Bₓ¹, welche zur zugeordneten Gruppe G₁ gehören und bei Berührung die Durchführung eines Schrittes veranlassen können, beleuchtet werden.

Die Untertasten Bₓ¹ können in Ausführungsformen der Erfindung ihrerseits wieder eine Auswahl von untergeordneten Untertasten C_{y}^{x} ermöglichen, wobei y ≥ 1 ist.

Die Gruppen von Funktionen hängen von der Art des mit dem Bedienpanel zu steuernden Gerätes ab. Ist das Gerät beispielsweise ein Waschtrockner, können sich unterschiedliche Gruppen von Funktionen auf einen Waschbetrieb sowie einen Trocknungsbetrieb beziehen. Dann würde beispielsweise eine Obertaste O₁ für den Waschbetrieb stehen und die Funktionen wären beispielsweise Waschprogramme, wobei die Untertasten Bₓ¹ für verschiedene Waschprogramme und sonstige diesbezügliche Eingaben zur Verfügung stehen.

Gegenstand der Erfindung ist außerdem ein Hausgerät mit einer Programmsteuerung und mit einem hierin beschriebenen Bedienpanel.

Erfindungsgemäß ist ein Hausgerät bevorzugt, das ausgewählt ist aus der Gruppe von Hausgeräten zur Behandlung von Gegenständen in einem Aufnahmebehälter, welche aus einer Waschmaschine, einem Trockner, einem Waschtrockner, einem Geschirrspülgerät und einem Kühlgerät besteht.

Die Erfindung hat mehrere Vorteile. So ist es mit dem erfindungsgemäßen Bedienpanel einer Bedienperson möglich, auf einfache Weise unter einer Vielzahl von Eingabemöglichkeiten auszuwählen. In Ausführungsformen der Erfindung ist beispielsweise die Auswahl und Durchführung eines in einem Hausgerät durchzuführenden Programmes erheblich vereinfacht. Überdies ermöglicht die Erfindung eine verbesserte Darstellung von Informationen über Programmauswahl und -ablauf, da eine verbesserte optische Darstellung möglich ist. Die Erfindung ermöglicht es, dass man durch eine verdichtete und intelligente Bauraummatrix gleichzeitig mehr Tasten darstellen kann. Zusätzlich kann eine Bedienperson über eine Art "Seitenwechsel" auf Kontextsensitive Inhalte aufmerksam gemacht werden. Dies ist in Ausführungsformen der Erfindung, bei denen die Bedienblende in einem Hausgerät eingesetzt wird, das ein Waschtrockner ist, der Wechsel zwischen Wasch- und Trocknungsoptionen.

Die Erfindung wird im Folgenden anhand der Figuren 1 bis 5 illustriert, in denen zur Vereinfachung lediglich die erfindungsgemäß relevanten Teile eines erfindungsgemäßen Bedienpanels dargestellt sind.
Fig. 1 zeigt eine Draufsicht auf ein erfindungsgemäßes Bedienpanel gemäß einer ersten nicht einschränkenden Ausführungsform, bei welcher zwei Obertasten und die den beiden Obertasten zugeordneten Untertasten sichtbar sind.
Fig. 2 zeigt eine Draufsicht auf das erfindungsgemäße Bedienpanel von Fig. 1, wobei allerdings nur die Obertaste O₁ sowie die ihr zugeordneten Untertasten gezeigt sind.
Fig. 3 zeigt eine Draufsicht auf das erfindungsgemäße Bedienpanel von Fig. 1, wobei allerdings nur die Obertaste O₂ sowie die ihr zugeordneten Untertasten gezeigt sind.
Fig. 4 zeigt in einer vereinfachten Explosionszeichnung einige Komponenten einer zweiten Ausführungsform eines erfindungsgemäßen Bedienpanels.
Fig. 5 zeigt einen senkrechten Schnitt durch eine dritte Ausführungsform eines erfindungsgemäßen Bedienpanels.

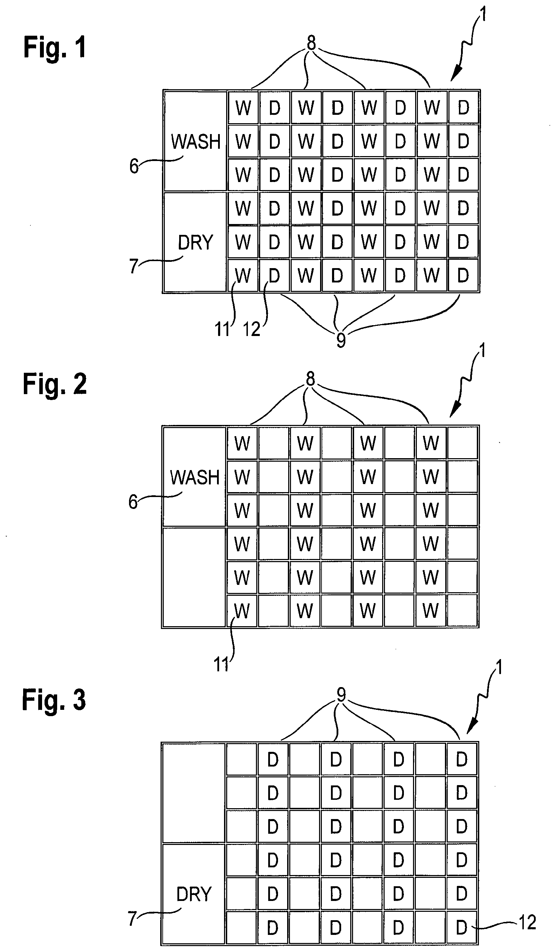

Fig. 1 zeigt eine Draufsicht auf ein erfindungsgemäßes Bedienpanel 1 gemäß einer ersten nicht einschränkenden Ausführungsform, bei welcher zwei Obertasten 6 und 7, welche mit den Bezeichnungen "WASH" und "DRY" beschriftet sind, und die den beiden Obertasten zugeordneten Untertasten, die jeweils mit einem "W" bzw. "D" beschriftet sind und in zwei Gruppen 8 und 9 angeordnet sind, sichtbar sind. Durch Betätigung des Obertaste WASH wird einem Benutzer der Zugriff auf die mit W beschrifteten Untertasten möglich. Ein solches Bedienpanel ist beispielsweise für die Bedienung eines Waschtrockners geeignet, in dem ein Waschbetrieb und ein Trocknungsbetrieb vorgesehen sind, wobei dem Waschbetrieb und dem Trocknungsbetrieb teilweise unterschiedliche Hardwarekomponenten des Waschtrockners zugeordnet sind sowie unterschiedliche Behandlungsprogramme für Wäschestücke.

Fig. 2 zeigt eine Draufsicht auf das erfindungsgemäße Bedienpanel 1 von Fig. 1, wobei allerdings nur die Obertaste O₁ ("WASH") sowie die ihr zugeordneten Untertasten ("W") der Gruppe 8 gezeigt sind. Damit zeigt Fig. 2 das Aussehen von Bedienpanel 1 nach einem Berühren der Obertaste O₁ ("WASH") und damit der Aktivierung von Berührelementen ("W"), welche die Gestaltung eines Waschbetriebes des Waschtrockners ermöglichen. Die Darstellung der einen Waschbetrieb regelbaren Berührtasten 6 bzw. 11 wird hier durch eine ansonsten nicht gezeigte gezielte Beleuchtung der ausgewählten Berührtasten erreicht, während die nicht ausgewählten, einem Trocknungsbetrieb des Waschtrockners zugeordneten Berührtasten nicht beleuchtet sind.

Fig. 3 zeigt eine Draufsicht auf das erfindungsgemäße Bedienpanel von Fig. 1 , wobei allerdings nur die Obertaste O₂ sowie die ihr zugeordneten Untertasten der Gruppe 9 gezeigt sind. Damit zeigt Fig. 3 das Aussehen von Bedienpanel 1 nach einem Berühren der Obertaste O₂ ("DRY") und damit der Aktivierung von Berührelementen ("D"), welche die Gestaltung eines Trocknungsbetriebes des Waschtrockners ermöglichen. Die Darstellung der einen Trocknungsbetrieb regelbaren Berührtasten 7 bzw. 12 wird hier durch eine ansonsten nicht gezeigte gezielte Beleuchtung der ausgewählten Berührtasten erreicht, während die nicht ausgewählten, einem Waschbetrieb des Waschtrockners zugeordneten Berührtasten nicht beleuchtet sind.

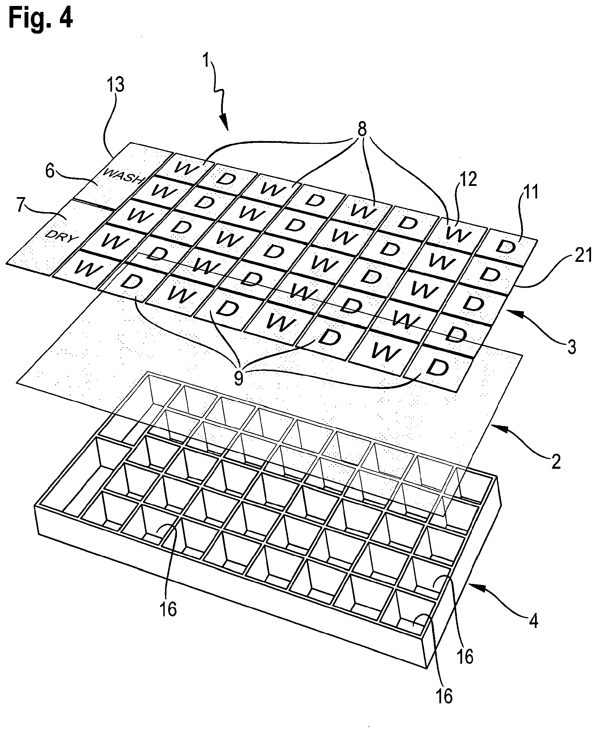

Fig. 4 zeigt in einer vereinfachten Explosionszeichnung einige Komponenten einer zweiten Ausführungsform eines erfindungsgemäßen Bedienpanels 1. Auf einem Substrat 2 aus Glas ist eine Sensorfolie 13 mit in einer Sensorschicht 3 befindlichen hier nicht näher gezeigten Sensorelementen angeordnet. Unterhalb von Substrat 2 ist als Komponente einer ansonsten nicht näher dargestellten Beleuchtungsvorrichtung 4 eine Matrix aus Lichtschächten 16 angeordnet, welche einzelnen Berührelementen 6,7,11,12 derart zugeordnet sind, dass hier nicht gezeigte Leuchtdioden als Leuchtmittel gezielt beleuchtet werden können. Die Oberfläche 21 des Bedienpanels 1 der hier gezeigten Ausführungsform weist zwei Obertasten Oₘ 6,7, welche hier mit "WASH" und "DRY" beschriftet sind, und zwei Gruppen Gₙ 8,9 von Untertasten Bₓⁿ 11,12 mit m, n, x jeweils ≥ 1 auf, wobei schalttechnisch jeder Obertaste Oₘ 6,7 eine Gruppe Gₙ 8,9 von Untertasten Bₓⁿ 11,12 derart zugeordnet ist, so dass bei Berührung einer Obertaste Oₘ 6,7 die Untertasten Bₓⁿ 11,12 aktiviert werden, welche zur zugeordneten Gruppe Gₙ 8,9 gehören. Die Untertasten Bₓⁿ 11,12 sind hier mit "W" bzw. "D" beschriftet und deuten dahinter stehende Funktionen oder Optionen für einen Waschbetrieb oder einen Trocknungsbetrieb eines Waschtrockners an.

Zur Durchführung eines erfindungsgemäßen Verfahrens wird zur Auswahl einer Gruppe von Funktionen, die vom Bedienpanel 1 zu steuern sind, eine dieser Gruppe von Funktionen zugeordnete Obertaste O₁ 6 berührt und nach der Berührung der Obertaste O₁ 6 steuert eine hier nicht gezeigte Steuereinheit im Bedienpanel 1 eine elektrische Anbindung der Untertasten Bₓⁿ 11,12 so, dass nur die Untertasten Bₓ¹ 12, welche zur zugeordneten Gruppe G₁ 8 gehören, bei Berührung die Durchführung eines Schrittes veranlassen können, z.B. eines bestimmten Waschprogrammes oder Trocknungsprogrammes.

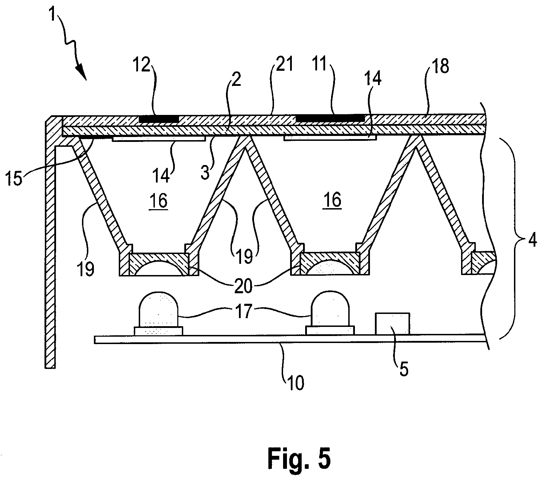

Fig. 5 zeigt einen senkrechten Schnitt durch eine dritte Ausführungsform eines erfindungsgemäßen Bedienpanels 1.

Bei der in Fig. 5 gezeigten dritten Ausführungsform eines Bedienpanels 1 sind die Sensorelemente 14 sowie eine elektrische Leitstruktur 15 in einer Sensorschicht 3 auf einem Substrat 2 aus Glas angeordnet und zwar auf einer einem Benutzer von Bedienpanel 1 entgegengesetzten Seite von Substrat 2. Die Sensorelemente 14 können beispielsweise aus einer eingebrannten elektrisch leitfähigen keramischen Paste gebildet sein, beispielsweise auf der Basis von Silber. Auf einer dem Benutzer von Bedienpanel 1 zugewandten Seite von Substrat 2 ist eine Displayfolie 18 aufgebracht. Auf der Displayfolie 18 und damit der Oberfläche 21 von Bedienpanel 1 sind in Fig. 5 als Berührelemente zwei Obertasten Oₘ 11 und 12 gezeigt, die entsprechenden Sensorelementen 14 auf dem Substrat 2 zugeordnet sind.

Unterhalb des beschichteten Substrates 2 ist eine Beleuchtungsvorrichtung 4 gezeigt. Die Beleuchtungsvorrichtung 4 umfasst hier eine Platine 10 zur Aufnahme von Leuchtmitteln 17, welche hier zwei anorganische Leuchtdioden sind. Auf der Platine 10 ist zudem eine Steuereinheit 5 gezeigt, welche die Berührungen der Sensorelemente 14 registriert und auswertet, und die Beleuchtungseinheit 4 entsprechend steuert.

Die Beleuchtungseinheit 4 umfasst bei dieser Ausführungsform auch Lichtschächte 16, in welchen das von den Leuchtdioden 17 abgestrahlte Licht zu den Obertasten 11 und 12 geleitet wird. Um das stark gebündelte Licht der Leuchtdioden 17 aufzufächern, sind an den Enden der Lichtschächte 16 Linsen 20 angeordnet. Außerdem nimmt der Querschnitt der Lichtschächte 16 in Richtung von Substrat 2 zu. Es kommt zu einer Auffächerung des von den Leuchtdioden 17 abgestrahlten Lichtes und somit zu einer gleichmäßigen Ausleuchtung der Berührelemente, hier der Obertasten 11 und 12.

19 bedeutet hier eine Lichtschachtwand, welche aus einem hier nicht gezeigten reflektierenden Material besteht oder mit diesem beschichtet ist.

### Bezugszeichenliste

- 1: Berührungsempfindliches, beleuchtbares Bedienpanel
- 2: Substrat
- 3: Sensorschicht
- 4: Beleuchtungsvorrichtung
- 5: Steuereinheit
- 6: Obertaste O₁
- 7: Obertaste O₂
- 8: Gruppe G₁ von Untertasten Bₓ¹
- 9: Gruppe G₂ von Untertasten Bₓ²
- 10: Platine zur Aufnahme von Leuchtmitteln
- 11: Untertasten Bₓ¹
- 12: Untertasten Bₓ²
- 13: mindestens teilweise lichtdurchlässige Folie mit Sensorelementen; Sensorfolie
- 14: Sensorelemente (Sensorflächen, Sensorelektroden)
- 15: Elektrische Leitstruktur
- 16: Lichtschacht
- 17: Leuchtmittel; z.B. Leuchtdioden
- 18: Displayfolie
- 19: Lichtschachtwand
- 20: Linse
- 21: Oberfläche des Bedienpanels

## Patentansprüche

1. Berührungsempfindliches, beleuchtbares Bedienpanel (1), umfassend ein Substrat (2), eine Vielzahl von Berührelementen (6,7,11,12) auf einer Oberfläche (21) des Bedienpanels (1), eine Sensorschicht (3) mit einer Vielzahl von Sensorelementen (14), wobei jedes Sensorelement (14) einem Berührelement (6,7,11,12) zugeordnet ist, eine Beleuchtungsvorrichtung (4), welche eingerichtet ist, um mindestens einen Teil der Berührelemente (6,7,11,12) zu beleuchten, sowie eine Steuereinheit (5), **dadurch gekennzeichnet, dass** die Berührelemente (6,7,11,12) mindestens zwei Obertasten Oₘ (6,7) und mindestens zwei Gruppen Gₙ (8,9) von Untertasten Bₓⁿ (11,12) mit m, n, x jeweils ≥ 1 aufweisen, wobei schalttechnisch jeder Obertaste Oₘ (6,7) mindestens eine Gruppe Gₙ (8,9) von Untertasten Bₓⁿ (11,12) derart zugeordnet ist, so dass bei Berührung einer Obertaste Oₘ (6,7) die Untertasten Bₓⁿ (11,12) aktiviert werden, welche zur zugeordneten Gruppe Gₙ (8,9) gehören.

2. Bedienpanel (1) nach Anspruch 1, **dadurch gekennzeichnet, dass** auf dem Substrat (2) eine mindestens teilweise lichtdurchlässige Folie (13) mit Sensorelementen (14) und einer elektrischen Leitstruktur (15) angeordnet ist.

3. Bedienpanel (1) nach Anspruch 1 oder 2, **dadurch gekennzeichnet, dass** die mindestens zwei Gruppen (8,9) von Untertasten Bₓⁿ (11,12) derart angeordnet sind, dass jeder Untertaste Bₓ¹ (12) einer Gruppe G₁ (8) mindestens zwei Untertasten Bₓ² (11) einer davon unterschiedlichen Gruppe G₂ (9) unmittelbar benachbart sind.

4. Bedienpanel (1) nach einem der Ansprüche 1 bis 3, **dadurch gekennzeichnet, dass** die Untertasten Bₓⁿ (11,12) in einer rechteckigen Matrix angeordnet sind, so dass jeder Untertaste Bₓⁿ (11,12) mindestens zwei seitlich benachbarte und mindestens eine diagonal benachbarte Untertaste zugeordnet sind.

5. Bedienpanel (1) nach einem der Ansprüche 1 bis 4, **dadurch gekennzeichnet, dass** die Untertasten Bₓⁿ (11,12) dadurch aktiviert werden, dass durch die Steuereinheit (5) jeder Untertaste Bₓⁿ (11,12) ein bei Berührung der Untertaste Bₓⁿ (11,12) auszuführender Schritt zugeordnet ist.

6. Bedienpanel (1) nach einem der Ansprüche 1 bis 5, **dadurch gekennzeichnet, dass** Steuereinrichtung (5) und Beleuchtungsvorrichtung (4) ausgestaltet sind, um bei Berührung einer Obertaste O₁ (6) die Untertasten Bₓ¹ (12) mindestens einer zugeordneten Gruppe G₁ (8) zu beleuchten.

7. Bedienpanel (1) nach Anspruch 6, **dadurch gekennzeichnet, dass** Steuereinrichtung (5) und Beleuchtungsvorrichtung (4) derart ausgestaltet sind, dass bei einer Beleuchtung der Untertasten Bₓ¹ einer Gruppe G₁ die unmittelbar benachbarten Untertasten Bₓ² (11) einer Gruppe G₂ (9) nicht beleuchtet werden.

8. Bedienpanel (1) nach einem der Ansprüche 1 bis 7, **dadurch gekennzeichnet, dass** das Substrat eine Glasplatte (2) beinhaltet.

9. Bedienpanel (1) nach Anspruch 8, **dadurch gekennzeichnet, dass** auf der Glasplatte (2) Sensorelemente (14) direkt oder in einer Sensorfolie (13) ausgebildet angeordnet sind.

10. Bedienpanel (1) nach einem der Ansprüche 1 bis 9, **dadurch gekennzeichnet, dass** die Beleuchtungsvorrichtung (4) mindestens ein Leuchtmittel (17) aufweist, das eine anorganische oder organische Leuchtdiode ist.

11. Bedienpanel (1) nach einem der Ansprüche 1 bis 10, **dadurch gekennzeichnet, dass** den Untertasten Bₓⁿ (11,12) und den Obertasten Oₘ (6,7) jeweils ein Lichtschacht (16) zugeordnet ist, so dass Licht aus mindestens einem Leuchtmittel (17) der Beleuchtungsvorrichtung (4) durch den Lichtschacht (16) in Richtung der jeweiligen Untertaste Bₓⁿ (11,12) oder Obertaste Oₘ (6,7) geleitet werden kann.

12. Bedienpanel (1) nach Anspruch 11, **dadurch gekennzeichnet, dass** jedem Lichtschacht (16) eine anorganische oder organische Leuchtdiode (17) zugeordnet ist.

13. Verfahren zum Betrieb eines berührungsempfindlichen, beleuchtbaren Bedienpanels (1), umfassend ein Substrat (2), eine Vielzahl von Berührelementen auf einer Oberfläche (21) des Bedienpanels (1), eine Sensorschicht (3) mit einer Vielzahl von Sensorelementen (14), wobei jedem Sensorelement (14) ein Berührelement (6,7,11,12) zugeordnet ist, eine Beleuchtungsvorrichtung (4), welche eingerichtet ist, um mindestens einen Teil der Berührelemente (6,7,11,12) zu beleuchten, sowie eine Steuereinheit (5), wobei die Berührelemente mindestens zwei Obertasten Oₘ (6,7) und mindestens zwei Gruppen Gₙ (8,9) von Untertasten Bₓⁿ (11,12) mit m, n, x jeweils ≥ 1 aufweisen, wobei schalttechnisch jeder Obertaste Oₘ (6,7) mindestens eine Gruppe Gₙ (8,9) von Untertasten Bₓⁿ (11,12) derart zugeordnet ist, so dass bei Berührung einer Obertaste Oₘ (6,7) die Untertasten Bₓⁿ (11,12) aktiviert werden, welche zur zugeordneten Gruppe Gₙ (8,9) gehören, **dadurch gekennzeichnet, dass** zur Auswahl einer Gruppe von Funktionen, die vom Bedienpanel (1) zu steuern sind, eine dieser Gruppe von Funktionen zugeordnete Obertaste O₁ (6) berührt wird und nach der Berührung der Obertaste O₁ (6) die Steuereinheit (5) eine elektrische Anbindung der Untertasten Bₓⁿ (11,12) so steuert, dass nur die Untertasten Bₓ¹ (12), welche zur zugeordneten Gruppe G₁ (8) gehören, bei Berührung die Durchführung eines Schrittes veranlassen können.

14. Hausgerät mit einer Steuereinrichtung und mit einem Bedienpanel (1) nach einem der Ansprüche 1 bis 12.

15. Hausgerät nach Anspruch 14, **dadurch gekennzeichnet, dass** es ausgewählt ist aus einer Gruppe von Hausgeräten zur Behandlung von Gegenständen in einem Aufnahmebehälter, welche besteht aus einer Waschmaschine, einem Trockner, einem Waschtrockner, einem Geschirrspülgerät und einem Kühlgerät.

## Claims

1. Touch-sensitive, illuminable operating panel (1), comprising a substrate (2), a plurality of touch elements (6,7,11,12) on a surface (21) of the operating panel (1), a sensor layer (3) with a plurality of sensor elements (14), wherein each sensor element (14) is paired with a touch element (6,7,11,12), an illuminating device (4) which is designed to illuminate at least some of the touch elements (6,7,11,12), and a control unit (5), **characterised in that** the touch elements (6,7,11,12) have at least two upper buttons Oₘ (6,7) and at least two groups Gₙ (8,9) of lower buttons Bₓⁿ(11,12), where m, n, x each ≥ 1, wherein the circuitry of each upper button Oₘ (6,7) is paired with at least one group Gₙ (8,9) of lower buttons Bₓⁿ (11,12) such that when an upper button Oₘ (6,7) is touched, the lower buttons Bₓⁿ (11,12) belonging to the corresponding group Gₙ (8,9) are activated.

2. Operating panel (1) according to claim 1, **characterised in that** an at least partially translucent film (13) with sensor elements (14) and an electrical conducting structure (15) is arranged on the substrate (2).

3. Operating panel (1) according to claim 1 or 2, **characterised in that** the at least two groups (8,9) of lower buttons Bₓⁿ (11,12) are arranged such that immediately adjacent to each lower button Bₓ¹ (12) of a group G₁ (8) are at least two lower buttons Bₓ² (11) of a different group G₂ (9).

4. Operating panel (1) according to one of claims 1 to 3, **characterised in that** the lower buttons Bₓⁿ (11, 12) are arranged in a rectangular matrix such that each lower button Bₓⁿ (11,12) is paired with at least two laterally adjacent and at least one diagonally adjacent lower button.

5. Operating panel (1) according to one of claims 1 to 4, **characterised in that** the lower buttons Bₓⁿ (11,12) are activated by the control unit (5) pairing each lower button Bₓⁿ (11,12) with a step to be performed when the lower button Bₓⁿ(11,12) is touched.

6. Operating panel (1) according to one of claims 1 to 5, **characterised in that** the control facility (5) and the illuminating device (4) are designed to illuminate the lower buttons Bₓ¹ (12) of at least one paired group G₁ (8) when an upper button O₁ (6) is touched.

7. Operating panel (1) according to claim 6, **characterised in that** the control facility (5) and the illuminating device (4) are designed such that when the lower buttons Bₓ¹ of a group G₁ are illuminated, the lower buttons Bₓ² (11) of a group G₂ (9) immediately adjacent are not illuminated.

8. Operating panel (1) according to one of claims 1 to 7, **characterised in that** the substrate contains a glass plate (2).

9. Operating panel (1) according to claim 8, **characterised in that** sensor elements (14) are arranged directly or embodied in a sensor film (13) on the glass plate (2).

10. Operating panel (1) according to one of claims 1 to 9, **characterised in that** the illuminating device (4) has at least one light source (17) which is an inorganic or organic light-emitting diode.

11. Operating panel (1) according to one of claims 1 to 10, **characterised in that** a light shaft (16) is paired with each of the lower buttons Bₓⁿ (11,12) and the upper buttons Oₘ (6,7) such that light can be guided from at least one light source (17) of the illuminating device (4) through the light shaft (16) in the direction of the respective lower button Bₓⁿ (11,12) or upper button Oₘ (6,7).

12. Operating panel (1) according to claim 11, **characterised in that** an inorganic or organic light-emitting diode (17) is paired with each light shaft (16).

13. Method for operating a touch-sensitive, illuminable operating panel (1) comprising a substrate (2), a plurality of touch elements on a surface (21) of the operating panel (1), a sensor layer (3) with a plurality of sensor elements (14), wherein each sensor element (14) is paired with a touch element (6,7,11,12), an illuminating device (4) which is designed to illuminate at least some of the touch elements (6,7,11,12), and a control unit (5), wherein the touch elements have at least two upper buttons Oₘ (6,7) and at least two groups Gₙ (8,9) of lower buttons Bₓⁿ (11,12), where m, n, x each ≥ 1, wherein the circuitry of each upper button Oₘ (6,7) is paired with at least one group Gₙ (8,9) of lower buttons Bₓⁿ (11,12) such that when an upper button Oₘ (6,7) is touched, the lower buttons Bₓⁿ (11,12) belonging to the corresponding group Gₙ (8,9) are activated, **characterised in that** to select a group of functions which are to be controlled by the operating panel (1), an upper button O₁ (6) paired with this group of functions is touched and after the upper button O₁ (6) is touched, the control unit (5) controls an electrical connection of the lower buttons Bₓⁿ (11,12) such that only the lower buttons Bₓ¹ (12) belonging to the corresponding group G₁ (8) can initiate the performance of a step when touched.

14. Household appliance with a control facility and with an operating panel (1) according to one of claims 1 to 12.

15. Household appliance according to claim 14, **characterised in that** it is selected from a group of household appliances for handling objects in a receptacle which comprises a washing machine, a tumble dryer, a washer-dryer, a dishwasher and a refrigerator.

## Revendications

1. Panneau de commande (1) tactile éclairable, comprenant un substrat (2), une pluralité d'éléments tactiles (6, 7, 11, 12) sur une surface (21) du panneau de commande (1), une couche de capteurs (3) munie d'une pluralité d'éléments capteurs (14), chaque élément capteur (14) étant attribué à un élément tactile (6, 7, 11, 12), un dispositif d'éclairage (4) qui est configuré pour éclairer au moins une partie des éléments tactiles (6, 7, 11, 12), ainsi qu'une unité de commande (5), **caractérisé en ce que** les éléments tactiles (6, 7, 11, 12) présentent au moins deux touches supérieures Oₘ (6, 7) et au moins deux groupes Gₙ (8, 9) de touches inférieures Bₓⁿ (11, 12) avec m, n, x respectivement ≥ 1, au moins un groupe Gₙ (8, 9) de touches inférieures Bₓⁿ (11, 12) étant attribué à chaque touche supérieure Oₘ (6, 7), du point de vue de la technique de commutation, de manière à ce que lorsqu'on touche une touche supérieure Oₘ (6, 7), les touches inférieures Bₓⁿ (11, 12) soient activées, lesquelles appartiennent au groupe attribué Gₙ (8, 9).

2. Panneau de commande (1) selon la revendication 1, **caractérisé en ce qu'**un film (13) au moins en partie perméable à la lumière, doté d'éléments capteurs (14) et d'une structure conductrice (15) électrique, est disposé sur le substrat (2).

3. Panneau de commande (1) selon la revendication 1 ou 2, **caractérisé en ce que** les au moins deux groupes (8, 9) de touches inférieures Bₓⁿ (11, 12) sont disposés de manière à ce qu'à chaque touche inférieure Bₓ¹ (12) d'un groupe G₁ (8), au moins deux touches inférieures Bₓ² (11) d'un groupe G₂ (9) qui en est différent y soient directement avoisinantes.

4. Panneau de commande (1) selon l'une quelconque des revendications 1 à 3, **caractérisé en ce que** les touches inférieures Bₓⁿ (11, 12) sont disposées dans une matrice rectangulaire, de sorte qu'à chaque touche inférieure Bₓⁿ (11, 12) sont attribuées au moins deux touches inférieures latéralement avoisinantes et au moins une touche inférieure diagonalement avoisinante.

5. Panneau de commande (1) selon l'une quelconque des revendications 1 à 4, **caractérisé en ce que** les touches inférieures Bₓⁿ (11, 12) sont activées du fait qu'une étape à exécuter lorsque la touche inférieure Bₓⁿ (11, 12) est touchée est attribuée à chaque touche inférieure Bₓⁿ (11, 12) par l'unité de commande (5).

6. Panneau de commande (1) selon l'une quelconque des revendications 1 à 5, **caractérisé en ce que** le dispositif de commande (5) et le dispositif d'éclairage (4) sont conçus, lorsqu'une touche supérieure O₁ (6) est touchée, pour éclairer les touches inférieures Bₓ¹ (12) d'au moins un groupe G₁ (8) attribué.

7. Panneau de commande (1) selon la revendication 6, **caractérisé en ce que** le dispositif de commande (5) et le dispositif d'éclairage (4) sont conçus de manière à ce que lors d'un éclairage des touches inférieures Bₓ¹ d'un groupe G₁, les touches inférieures Bₓ² (11) d'un groupe G₂ (9), directement avoisinantes, ne soient pas éclairées.

8. Panneau de commande (1) selon l'une quelconque des revendications 1 à 7, **caractérisé en ce que** le substrat comprend une plaque de verre (2).

9. Panneau de commande (1) selon la revendication 8, **caractérisé en ce que** des éléments capteurs (14) sont disposés sur la plaque de verre (2) directement ou en étant réalisés dans un film capteur (13).

10. Panneau de commande (1) selon l'une quelconque des revendications 1 à 9, **caractérisé en ce que** le dispositif d'éclairage (4) présente au moins une lampe (17) qui est une diode électroluminescente anorganique ou organique.

11. Panneau de commande (1) selon l'une quelconque des revendications 1 à 10, **caractérisé en ce qu'**un puits de lumière (16) est respectivement attribué aux touches inférieures Bₓⁿ (11, 12) et aux touches supérieures Oₘ (6, 7) de sorte que la lumière provenant d'au moins une lampe (17) du dispositif d'éclairage (4) peut être guidée à travers le puits de lumière (16) en direction de la touche inférieure Bₓⁿ (11, 12) respective ou de la touche supérieure Oₘ (6, 7) respective.

12. Panneau de commande (1) selon la revendication 11, **caractérisé en ce qu'**une diode électroluminescente (17) anorganique ou organique est attribuée à chaque puits de lumière (16).

13. Procédé de fonctionnement d'un panneau de commande (1) tactile éclairable, comprenant un substrat (2), une pluralité d'éléments tactiles sur une surface (21) du panneau de commande (1), une couche de capteurs (3) munie d'une pluralité d'éléments capteurs (14), un élément tactile (6, 7, 11, 12) étant attribué à chaque élément capteur (14), un dispositif d'éclairage (4) qui est configuré pour éclairer au moins une partie des éléments tactiles (6, 7, 11, 12), ainsi qu'une unité de commande (5), les éléments tactiles présentant au moins deux touches supérieures Oₘ (6, 7) et au moins deux groupes Gₙ (8,9) de touches inférieures Bₓⁿ (11, 12) avec m, n, x respectivement ≥ 1, au moins un groupe Gₙ (8, 9) de touches inférieures Bₓⁿ (11, 12) étant attribué à chaque touche supérieure Oₘ (6, 7), du point de vue de la technique de commutation, de manière à ce que lorsqu'on touche une touche supérieure Oₘ (6, 7), les touches inférieures Bₓⁿ (11, 12) soient activées, lesquelles appartiennent au groupe attribué Gₙ (8, 9), **caractérisé en ce que** pour la sélection d'un groupe de fonctions, lesquelles sont à commander par le panneau de commande (1), une touche supérieure O₁ (6) attribuée à ce groupe de fonctions est touchée et, après que la touche supérieure O₁ (6) ait été touchée, **en ce que** l'unité de commande (5) commande une liaison électrique des touches inférieures Bₓⁿ (11, 12) de manière à ce que seulement les touches inférieures Bₓ¹ (12), lesquelles appartiennent au groupe G₁ (8) attribué, puissent inciter la réalisation d'une étape.

14. Appareil ménager comprenant un dispositif de commande et comprenant un panneau de commande (1) selon l'une quelconque des revendications 1 à 12.

15. Appareil ménager selon la revendication 14, **caractérisé en ce qu'**il est sélectionné à partir d'un groupe d'appareils ménagers destinés au traitement d'objets dans une cuve de logement, lequel est constitué d'un lave-linge, d'un sèche-linge, d'un lave-linge séchant, d'un lave-vaisselle et d'un appareil frigorifique.
